# EUROPÄISCHE PATENTSCHRIFT

(11) **EP 3 637 064 B1**
(45) Veröffentlichungstag und Bekanntmachung des Hinweises auf die Patenterteilung: **21.08.2024**
(21) Anmeldenummer: 18199933.5
(22) Anmeldetag: 11.10.2018
(51) Int. Cl.: G01F 23/80, G01F 25/20, G01D 4/00, G05B 1/00, G08C 19/00, G08B 21/00, G06F 1/3209, G06F 1/3212, G06F 1/3234, G06F 1/3287, H04Q 9/00, G01F 23/284, G01S 13/88, G06F 1/3203

(54) **BATTERIEBETRIEBENES FÜLLSTANDMESSGERÄT MIT RESTLEBENSDAUERBESTIMMUNGSVORRICHTUNG**
BATTERY-OPERATED FILL LEVEL MEASURING DEVICE WITH MEANS FOR DETERMINING REMAINING SERVICE LIFE
APPAREIL DE MESURE DE NIVEAU DE REMPLISSAGE ACTIONNÉ PAR PILES ET POURVU DE MOYENS DE DÉTERMINATION DE LA DURÉE DE SERVICE

(43) Veröffentlichungstag der Anmeldung: 15.04.2020
(73) Patentinhaber: VEGA Grieshaber KG, 77709 Wolfach (DE)
(72) Erfinder: WELLE, Roland, 77756 Hausach (DE); BÖRSIG, Jörg, 77776 Schapbach (DE); WÄLDE, Steffen, 78078 Niedereschach (DE)
(74) Vertreter: Maiwald GmbH

(56) Entgegenhaltungen:
- EP-A1- 3 082 215
- WO-A1-03/091672
- DE-U1- 202011 110 275
- IE-A2- S20 020 317
- US-A1- 2008 079 589
- US-A1- 2015 002 185

## Beschreibung

### Gebiet der Erfindung

Die Erfindung betrifft die Füllstandmesstechnik. Insbesondere betrifft die Erfindung ein batteriebetriebenes Füllstandmessgerät, ein Verfahren zum Bestimmen einer Restlebensdauer einer Batterie eines Messgeräts, ein Programmelement und ein computerlesbares Medium.

### Technischer Hintergrund

Füllstandmessgeräte werden zum größten Teil über Kabel mit Energie versorgt. Über Kabel werden zudem die Messdaten an eine Leitstelle gesendet. Der Aufwand für die Verdrahtung ist teilweise erheblich und schränkt den Einsatzbereich der Messgeräte ein.

WO 03/091672 A1 beschreibt ein Füllstandmesssystem, das die Batteriespannung überwacht.

US 2015/0002185 A1 beschreibt ein drahtloses Feldgerät mit einem Prozesssensor, einem Gehäuse, einem Transmitter und einem Leistungsmodul.

Die EP 3 082 215 A1 beschreibt eine sichere Leistungsversorgung für ein industrielles Steuersystem.

US 2008/0079589 A1 beschreibt eine Sensoreinrichtung mit einem persistenten Niedrigenergiebeacon und einer Batterieüberwachungseinheit.

DE 20 2011 110 275 U1 beschreibt eine Anordnung zur Bestimmung der Restlebensdauer einer Batterie für batteriebetriebene elektronische Geräte.

IES 2002 0317 A2 beschreibt ein batteriebetriebenes Füllstandmessgerät.

### Zusammenfassung

Es ist eine Aufgabe der Erfindung, den Einsatzbereich von Füllstandmessgeräten zu vergrößern.

Diese Aufgabe wird durch die Merkmale der unabhängigen Patentansprüche gelöst. Weiterbildungen der Erfindung ergeben sich aus den Unteransprüchen und der folgenden Beschreibung von Ausführungsformen.

Ein erster Aspekt betrifft ein batteriebetriebenes Füllstandmessgerät mit einer Batterie und einer Restlebensdauerbestimmungseinrichtung, welche beispielsweise einen Prozessor und eine oder mehrere Messschaltungen oder Messeinrichtungen aufweist. Die Restlebensdauerbestimmungseinrichtung ist eingerichtet zur Bereitstellung von Informationen, aus denen sich ein Mindestwert der Batterierestlaufzeit berechnen lässt.

Beispielsweise kann das Messgerät eingerichtet sein, den Mindestwert der Batterierestlaufzeit aus dem Alter oder den Betriebsstunden der Batterie und unter Kenntnis des Messablaufs des Füllstandmessgeräts zu bestimmen. Kennt die Restlebensdauerbestimmungseinrichtung den pro Messung erforderlichen Energiebedarf des Füllstandmessgeräts sowie den zeitlichen Abstand der zukünftig durchzuführenden Messungen voneinander, kann ein Mindestwert für die Batterierestlaufzeit berechnet werden, insbesondere wenn der aktuelle Ladezustand der Batterie bekannt ist.

Gemäß einer Ausführungsform können in die Bestimmung dieses Mindestwerts auch andere Informationen einfließen, welche sich die Restlebensdauerbestimmungseinrichtung beschaffen kann. Beispiele hierfür sind die der Batterie tatsächlich entnommene Ladungsmenge, die aktuelle Batteriespannung, die aktuelle Temperatur der Batterie oder des Messgeräts, das aktuelle Datum und ggf. die Uhrzeit, die bisherige Anzahl an Messungen, der geplante zeitliche Abstand zukünftiger Messungen, die bisherige Anzahl an (Funk)Übertragungen von Messwerten, der geplante zeitliche Abstand von Funkübertragungen, die Umgebungstemperatur, die bisherige Anzahl an Messwertanzeigen bzw. die bisherige Dauer von Messwertanzeigen, der geplante zeitliche Abstand von Messwertanzeigen, die geplante Messwertanzeigezeit, der bisherige geleistete Rechenaufwand des Messgeräts und der geplante zukünftige Rechenaufwand.

Das Füllstandmessgerät kann eingerichtet sein, die Berechnung des Mindestwertes selber durchzuführen. Alternativ kann vorgesehen sein, dass derjenige Teil der Restlebensdauerbestimmungseinrichtung, der im Messgerät verbaut ist, die benötigten Informationen bereitstellt und diese dann über eine Drahtlosschnittstelle (Funkmodul) an einen extern angeordneten Teil der Restlebensdauerbestimmungseinrichtung übertragen wird. Hierbei kann es sich zum Beispiel um eine Cloud handeln oder einen externen Server, der dann die Berechnungen vornimmt.

Gemäß einer Ausführungsform kann vorgesehen sein, dass das Messgerät, der Server oder die Cloud Maßnahmen ergreift, wenn der Ladezustand der Batterie unter einen bestimmten Schwellwert fällt bzw. der berechnete Mindestwert der Batterierestlaufzeit unter einen bestimmten Schwellwert fällt oder die Anzahl an noch durchführbaren Messungen (bevor die Batterie entleert ist) unter einen bestimmten Schwellwert fällt.

Auf diese Weise kann die Lebensdauer der Batterie verlängert werden und es kann verhindert werden, dass die Batterie vollständig entleert wird. Beispielsweise kann der Abstand der aufeinanderfolgenden Messzyklen vergrößert werden. Auch kann von weiteren Funkübertragungen abgesehen werden oder es kann der Abstand zwischen aufeinanderfolgenden Funkübertragungen vergrößert werden. Auch kann vorgesehen sein, dass in diesem Fall die Messgenauigkeit reduziert wird, um pro Messzyklus Energie zu sparen.

Auch kann vorgesehen sein, dass der Server bzw. die Cloud rechtzeitig in den Messablauf eingreift und die Parametrierung des Messgeräts ändert, um Energie zu sparen, damit ein Leerlaufen der Batterie verhindert wird.

Gemäß einer Ausführungsform ist diese Funktion in das Messgerät einprogrammiert, so dass keine Steuerung von außen erforderlich ist, um das Leerlaufen der Batterie zu verhindern. Insbesondere kann das Messgerät eingerichtet sein, dass das Messgerät in einen Schlafmodus fällt, wenn es der Ladezustand der Batterie nur mehr ermöglicht, eine geringe Anzahl von Messungen durchzuführen. Dieser Schlafzustand wird erst dann verlassen, wenn dies von extern angefordert wird, beispielsweise vom Benutzer. Dann wacht das Messgerät auf und führt eine letzte Messung und Funkübertragung durch.

Gemäß einer weiteren Ausführungsform der Erfindung weist die Restlebensdauerbestimmungseinrichtung eine Zähleinrichtung auf, welche eingerichtet ist, die vom Füllstandmessgerät durchgeführten Messungen zu zählen.

Gemäß einer weiteren Ausführungsform der Erfindung ist die Zähleinrichtung eingerichtet, die Anzahl an Messwertanzeigeereignissen und/oder an Messwertübermittlungen an einen externen Empfänger zu zählen.

Gemäß einer weiteren Ausführungsform der Erfindung weist die Restlebensdauerbestimmungseinrichtung ein Coulomb-Meter auf, welches eingerichtet ist, die der Batterie entnommene Ladungsmenge zu messen.

Gemäß einer weiteren Ausführungsform der Erfindung ist das Coulomb-Meter in einer Batteriespannungsregeleinheit des Füllstandmessgeräts integriert.

Gemäß einer weiteren Ausführungsform der Erfindung weist die Restlebensdauerbestimmungseinrichtung eine Batteriespannungsregeleinheit auf, welche eingerichtet ist, die Spannung der Batterie zu messen.

Gemäß einer weiteren Ausführungsform der Erfindung weist die Restlebensdauerbestimmungseinrichtung einen Temperatursensor auf, welcher eingerichtet ist, die Temperatur der Batterie zu messen.

Gemäß einer weiteren Ausführungsform der Erfindung weist die Restlebensdauerbestimmungseinrichtung eine Echtzeituhr auf, welche eingerichtet ist, das aktuelle Datum und/oder die aktuelle Zeit zu bestimmen und mit einem Zeitstempel der Batterie zu vergleichen, der beispielsweise werksseitig im Messgerät gespeichert ist.

Gemäß einer weiteren Ausführungsform der Erfindung weist das batteriebetriebene Füllstandmessgerät einen Datenspeicher auf, in welchem Informationen über die Art und die Kapazität der verwendeten, verbauten Batterie gespeichert sind.

Gemäß einer weiteren Ausführungsform der Erfindung ist die Restlebensdauerbestimmungseinrichtung eingerichtet, die Anzahl der vom Füllstandmessgerät durchgeführten Messungen, die Anzahl an Messwertanzeigeereignissen und/oder an Messwertübermittlungen an den externen Empfänger, die der Batterie entnommene Ladungsmenge, die Spannung der Batterie und/oder das aktuelle Datum, die aktuelle Zeit und/oder die Informationen über die Art und die Kapazität der Batterie in die bereitgestellten Informationen aufzunehmen oder bei der Berechnung des Mindestwertes der Batterierestlaufzeit zu berücksichtigen.

Gemäß einer weiteren Ausführungsform der Erfindung ist die Batterie im Füllstandmessgerät fest verbaut, so dass sie nicht ausgewechselt werden kann.

Gemäß einer weiteren Ausführungsform der Erfindung ist das Füllstandmessgerät ausschließlich batteriebetrieben.

Insbesondere kann vorgesehen sein, dass die Batterie und/oder sämtliche Komponenten des Füllstandmessgeräts in einem Gehäuse verbaut sind, welches sich nicht öffnen lässt. Beispielsweise können die Komponenten in dem Gehäuse eingegossen sein. Hierdurch kann ein sehr effektiver Explosionsschutz und/oder chemischer Schutz sichergestellt werden.

Ein weiterer Aspekt betrifft ein Verfahren zum Bestimmen einer Restlebensdauer einer Batterie eines Messgeräts, bei dem Informationen bereitgestellt werden, aus denen sich ein Mindestwert der Batterierestlaufzeit berechnen lässt. Dies erfolgt durch eine Restlebensdauerbestimmungseinrichtung des Messgeräts. Danach wird ein Mindestwert der Batterierestlaufzeit aus diesen Informationen berechnet, und zwar durch die Restlebensdauerbestimmungseinrichtung, die im Messgerät integriert ist, oder eine externe Auswerteeinrichtung.

Ein weiterer Aspekt betrifft ein Programmelement, das, wenn es auf einem Prozessor oder einer Rechenschaltung eines Messgeräts ausgeführt wird, das Messgerät anleitet, die oben und im Folgenden beschriebenen Schritte durchzuführen.

Ein weiterer Aspekt betrifft ein computerlesbares Medium, auf dem das oben beschriebene Programmelement gespeichert ist.

Im Folgenden werden mit Verweis auf die Figuren Ausführungsformen der Erfindung beschrieben. Die Darstellungen in den Figuren sind schematisch und nicht maßstäblich. Werden in den Figuren die gleichen Bezugszeichen verwendet, so bezeichnen diese gleiche oder ähnliche Elemente.

### Kurze Beschreibung der Figuren

Fig. 1 zeigt ein Füllstandmesssystem mit einem batteriebetriebenen Füllstandmessgerät.
Fig. 2 zeigt ein weiteres Füllstandmesssystem mit einem batteriebetriebenen Füllstandmessgerät.
Fig. 3 zeigt ein Flussdiagramm eines Verfahrens.

### Detaillierte Beschreibung von Ausführungsformen

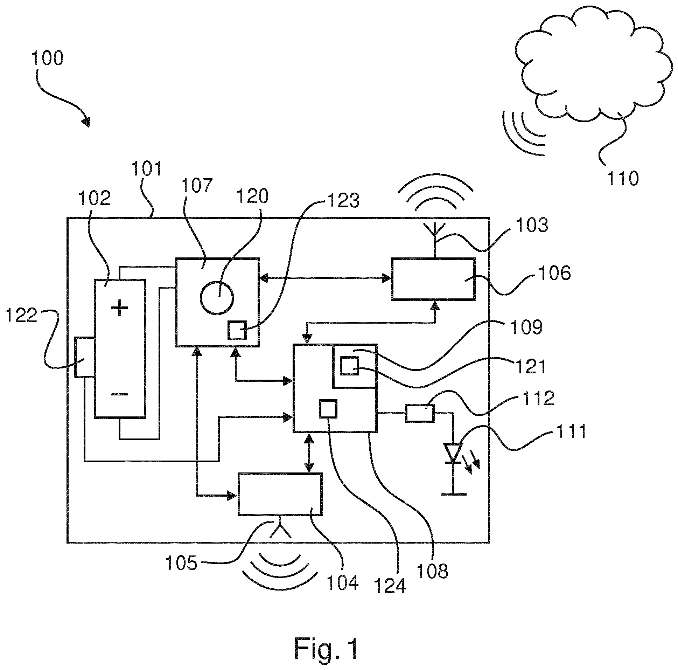

Fig. 1 zeigt eine Messsystem mit einem Messgerät 100, beispielsweise in Form eines Füllstandmessgeräts. Das Messgerät 100 kann insbesondere ein Füllstandradargerät sein, aber beispielsweise auch ein Grenzstandsensor oder ein Druckmessgerät. Es kann aber auch ein anderes batteriebetriebenes Messgerät sein.

Insbesondere kann das Messgerät kabellos ausgeführt sein, so dass es ohne Verkabelungsaufwand einsetzbar ist. Beispielsweise kann es direkt an oder in einem mobilen Behälter angebracht werden.

Das batteriebetriebene Füllstandmessgerät kann flexibel eingesetzt werden und weist zur Auslesung der Messdaten ein Funkmodul mit entsprechendem Funkstandard auf. Der Duty Cycle, also das Verhältnis der Länge der Messung und Messdatenübertragung zur Messpause, ist ein maßgeblicher Faktor für die Dauer, während der das Füllstandmessgerät ohne einen Wechsel der Batterie einsetzbar ist.

Wird dieses Verhältnis sehr groß, werden also die Messpausen sehr lange, können Maßnahmen im Energiemanagement der Messgeräteschaltung getroffen werden, um weiter Energie zu sparen. Hierfür können Softwareroutinen, Bauteile und Bauteilbeschaltungen aus dem Ultra-Low-Power-Segment Anwendung finden. Zur Erhöhung der Benutzerfreundlichkeit und zur Vermeidung von Messausfällen kann vorgesehen sein, dass die voraussichtliche Batterierestlaufzeit berechnet und ausgegeben wird.

Um das Füllstandmessgerät für den Einsatz in explosionsgefährdeten Bereichen auszuführen und dessen Zulassung hierfür zu erleichtern, kann vorgesehen sein, dass die Batterie bzw. der Akku des Füllstandmessgeräts nicht auswechselbar ist.

Zusätzliche Halterungen, die für kabellose Geräte mit wechselbarem Energiespeicher erforderlich sind, sind nicht notwendig. Des Weiteren sind keine Gehäuseöffnungen nötig, was den Herstellungsaufwand des Messgeräts weiter herabsetzt.

Da keine Öffnungen in der Gehäusewand notwendig sind und es insbesondere vorgesehen sein kann, dass die Batterie und die elektronische Schaltung mit einer Vergussmasse umschlossen sind, kann der Einsatz des Geräts in explosionsgefährdeten Bereichen erleichtert werden.

Das Messgerät weist ein Funkmodul 106 mit einer Antenne 103 auf. Hierbei handelt es sich beispielsweise um ein GSM-, WiFi-, LoRa-, oder ein Sigfox-Modul. Vorzugsweise wird ein Funkstandard verwendet, der möglichst wenig Energie für die Übertragung der Messwerte benötigt.

Das Füllstandmessgerät eignet sich insbesondere zur Anbringung an mobilen Behältern, die beispielsweise zur Entleerung oder Befüllung ihren Standort wechseln. Bei diesem Einsatzzweck ist es wichtig, dass der Betreiber des Systems Informationen über den Ladezustand der Batterie erhält. Ein Grund hierfür liegt darin, dass der Betreiber im Falle, dass der Sensor nicht mehr antwortet, nicht unterscheiden kann, ob sich der Sensor nicht mehr in Reichweite seines Funknetzes befindet oder die Batterie leer ist.

Die Bestimmung des Ladezustands der Batterie 102, beispielsweise eine Lithium-Ionen-Batterie, ist anspruchsvoll. Verschiedenste Effekte können die Restkapazität einer Batterie beeinflussen. Hierzu zählen: Alter der Batterie, Umgebungstemperatur, eventuelle Beschädigungen der Außenhülle und zugehörige Oxidation, sowie Anzahl, Dauer und Häufigkeit von während der Betriebsphase auftretenden Stromspitzen. Hinzu kommt, dass sich diese Effekte abhängig von Art und Bauform des Messgeräts und der Batterie unterschiedlich auswirken.

Die Restlebensdauerbestimmungseinrichtung 109 kann über verschiedene Verfahren die Restlaufzeit der eingebauten Batterie 102 bestimmen. Die Restlebensdauerbestimmungseinrichtung 109 kann dabei auf Daten integrierter Sensoren 120, 121, 122, 123, 124 zurückgreifen.

Die Restlebensdauerbestimmungseinrichtung 109 kann beispielsweise Informationen eines Coulomb-Meters 120 erhalten, welches die aus der Batterie 102 entnommene Ladungsmenge misst. Das Coulomb-Meter kann dabei in der Batteriespannungsregeleinheit 107 integriert sein.

Alternativ oder zusätzlich kann über die Batteriespannungsregeleinheit 107 die Batteriespannung gemessen werden, die ebenfalls Aufschluss über den aktuellen Ladezustand der Batterie geben kann.

Für eine genauere Bestimmung des Mindestwertes der Batterierestlaufzeit können weitere Sensoren vorgesehen sein. Beispielsweise kann die aktuelle Temperatur über einen Temperaturfühler oder Temperatursensor 122 ausgelesen werden. Der Temperaturfühler kann dabei in den Komponenten 107, 106, 108 oder 104 integriert oder ein eigenständiges Bauteil sein, das beispielsweise direkt im Bereich der Batterie 102 angebracht ist.

Außerdem kann über eine Echtzeituhr (real time clock) 123 das aktuelle Datum bestimmt werden und mit einem werksseitig eingespeicherten Zeitstempel verglichen werden, um so das Alter der Batterie 102 zu bestimmen. Die Echtzeituhr 123 kann dabei in der Batteriespannungsregeleinheit 107 oder des im Prozessor des Messgeräts integrierten Teils 109 der Restlebensdauerbestimmungseinrichtung integriert sein.

Zudem können Informationen darüber, wie oft bereits ein Messwert über die Sensoreinheit 104 erfasst, ausgewertet und angezeigt bzw. über das Funkmodul 106 versendet wurde, bei der Bestimmung der Batterierestlaufzeit hilfreich sein. Die Sensoreinheit 104 kann dabei beispielsweise nach dem Radarprinzip arbeiten, wofür, zur Abstrahlung und zum Empfang des Messsignals, eine Radarantenne 105 vorgesehen ist. Hierfür muss bekannt sein, wie viel Strom ein Messzyklus inklusive Messdatenauswertung und gegebenenfalls -übertragung benötigt. Es sollte also insbesondere bekannt sein, wie viel Strom fließt, während das Funkmodul Daten versendet und empfängt. Die Strom-Kennwerte dieser und weiterer Schaltungskomponenten (zum Beispiel Echtzeituhr, LEDs, ...) können bereits werksseitig bestimmt und in einem Speicher 124 abgelegt werden.

Weitere Informationen, die bereits werksseitig im Speicher abgelegt werden können, sind Art und Kapazität der Batterie, von denen die Berechnung der Batterierestlaufzeit ebenfalls abhängt. Zudem kann für verschiedene Batterietypen werksseitig eine Worst-Case-Betrachtung gemacht werden, welche einen Wert für die Mindest-Batterierestlaufzeit im schlechtesten Fall liefert. Diese Zeit kann ebenfalls im Speicher abgelegt werden.

Ein weiterer wichtiger Punkt, der zu berücksichtigen ist, ist die Parametrierung des Sensors. Dieser kann so ausgestaltet sein, dass über eine Parametrierung eingestellt werden kann, wie oft der Sensor (also das Messgerät) eine Messung durchführt und wann und ob dieser den ermittelten Messwert über das Funkmodul 106 absetzt. Die Information über die Parametrierung ist wichtig, wenn die Batterierestlaufzeit in einer Zeiteinheit (Tage, Stunden, Minuten, ...) angegeben werden soll.

Im Gegensatz dazu kann die Batterierestlaufzeit auch in Messzyklen angegeben werden.

Anhand dieser und weiterer möglicher Daten und zusätzlichen Erfahrungswerten kann die Restlaufzeit der Batterie vom Füllstandmessgerät 100 geschätzt werden.

Die Berechnungen, die die Restlebensdauerbestimmungseinrichtung 109 für die Bestimmung der Batterierestlaufzeit durchzuführen hat, können in einer Ausführungsform auf der zentralen Steuer- und Recheneinheit (Prozessor) 108 (beispielsweise ein Mikrocontroller) stattfinden.

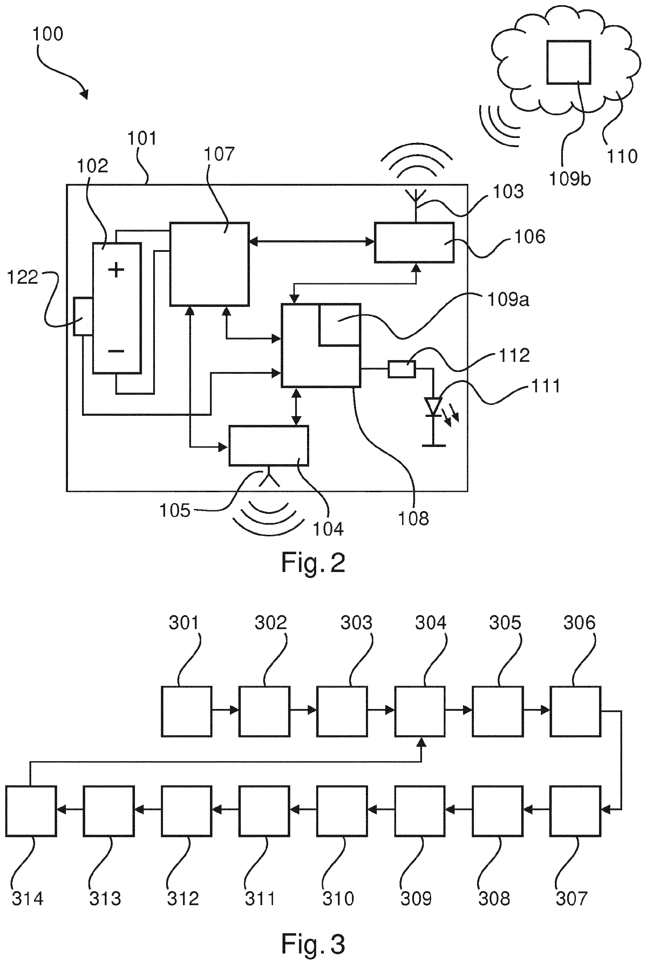

In einer weiteren Ausführungsform werden die von der Restlebensdauerbestimmungseinrichtung 109a (vgl. Fig. 2) bestimmten Daten unverarbeitet über das Funkmodul an eine Cloud 110 oder einen externen Server geschickt, in der/dem die Berechnungen zur Bestimmung der Batterierestlaufzeit (des Mindestwertes) von einer virtuellen Restlebensdauerbestimmungseinrichtung 109b durchgeführt werden.

In der Cloud 110 kann dem Benutzer des Füllstandmessgeräts 100 beispielsweise ebenfalls mitgeteilt werden, wie viele Messzyklen vom batteriebetriebenen Füllstandmessgerät 100 noch zu erwarten sind und gegebenenfalls bei kritischer Restlaufzeit ein Warnhinweis ausgegeben werden.

Weiterhin kann die in der Cloud berechnete Batterierestlaufzeit wieder per Funk auf das Füllstandmessgerät zurückgesendet werden.

Bei kritischer Restlaufzeit kann am Sensor ein Warnhinweis ausgegeben werden, beispielsweise über ein optisches Signal mittels einer LED 111 in Kombination mit einem Vorwiderstand 112.

Die Zeitpunkte, Häufigkeit und Abstände der Warnhinweise über die Batterierestlaufzeit können werksseitig oder über das Funkmodul parametriert werden. Es ist möglich, dass neben dem Sensorbetreiber ebenfalls das Werk benachrichtigt wird, damit gegebenenfalls eine Bereitstellung eines neuen Sensors ausgelöst werden kann. Gleichzeitig können die sensorseitig gesammelten Daten, die zur Berechnung der Batterierestlaufzeit notwendig sind, ebenfalls gegebenenfalls anonymisiert an das Werk übermittelt werden, um damit die Algorithmen zur Berechnung der Batterierestlaufzeit künftiger Sensoren weiter zu verfeinern.

Die Restlebensdauerbestimmungseinrichtung 109, 109a, 109b kann insbesondere eingerichtet sein, verschiedene Sensordaten zu sammeln, daraus eine Restlebensdauer der Batterie zu berechnen und diese dem Nutzer zu signalisieren. Möglichkeiten der Signalisierung sind eine LED, eine Nachricht (Email, SMS,...) auf ein Mobiltelefon oder die Signalisierung in einer Benutzeroberfläche auf einem Monitor. Möglich ist auch ein Rückwärtszähler, der anzeigt, wie viele Messungen mindestens noch möglich sind.

Das gesamte Messgerät kann in einem Gehäuse 101 integriert sein, welches geschlossen ist und beispielsweise einstückig ausgeführt ist. Insbesondere kann vorgesehen sein, dass sämtliche Komponenten in dem Gehäuse eingegossen sind.

Fig. 3 zeigt ein Flussdiagramm eines Verfahrens gemäß einer Ausführungsform. In Schritt 301 erfolgt eine werksseitige Programmierung des Füllstandmessgeräts, so dass es die oben beschriebenen Verfahrensschritte ausführen kann und auf die werksseitig zu speichernden Daten zugreifen kann. In Schritt 302 erfolgt die Auslieferung an den Kunden, der dann in Schritt 303 das Füllstandmessgerät startet. In Schritt 304 werden die entsprechenden Schaltungskomponenten aus den Energiesparmodi aufgeweckt und in Schritt 305 erfolgt eine Erfassung und eine Auswertung der Messdaten, also beispielsweise eine Ermittlung des Füllstands, Grenzstands oder Drucks.

In Schritt 306 wird der Batteriezustand des Messgeräts erfasst, beispielsweise indem die Batteriespannung gemessen wird oder der in Schritten 304 und 305 von der Batterie abgegebene Strom ermittelt wird. In Schritt 307 werden Daten der übrigen im Messgerät angeordneten Sensoren abgefragt (Zeit, Temperatur, ...) und in Schritt 308 erfolgt eine Berechnung des Mindestwertes der Batterierestlaufzeit mit den werksseitig abgelegten Daten, der aktuellen Sensorparametrierung und den Daten, die von den geräteinternen Sensoren ermittelt wurden. In Schritt 309 erfolgt eine Übertragung der Messdaten über das Funkmodul an einen Empfänger und in Schritt 310 eine Übertragung der Batterierestlaufzeit über das Funkmodul an einen oder mehrere Empfänger. In Schritt 311 wird gegebenenfalls ein Warnhinweis in der Cloud, im Server, beim Benutzer und/oder direkt am Sensor angezeigt, nämlich wenn die Batterierestlaufzeit unter einen bestimmten Schwellwert gefallen ist. In Schritt 312 werden neue Parametrierdaten empfangen, beispielsweise die gewünschte nächste Messzeit. Und in Schritt 313 eine Messpause eingeleitet, während der das Messgerät einen Energiesparmodus einnimmt. In Schritt 314 erfolgt ein neuer Messzyklus, der mit Schritt 304 startet.

Ergänzend sei darauf hingewiesen, dass "umfassend" und "aufweisend" keine anderen Elemente oder Schritte ausschließt und die unbestimmten Artikel "eine" oder "ein" keine Vielzahl ausschließen. Ferner sei darauf hingewiesen, dass Merkmale oder Schritte, die mit Verweis auf eines der obigen Ausführungsbeispiele beschrieben worden sind, auch in Kombination mit anderen Merkmalen oder Schritten anderer oben beschriebener Ausführungsbeispiele verwendet werden können. Bezugszeichen in den Ansprüchen sind nicht als Einschränkungen anzusehen.

## Patentansprüche

1. Batteriebetriebenes Füllstandmessgerät (100) und externer Server oder Cloud (110), das batteriebetriebene Füllstandmessgerät aufweisend:
eine Batterie (102);
eine Restlebensdauerbestimmungseinrichtung (109, 109a), eingerichtet zur Bereitstellung von Informationen, und zur Berechnung eines Mindestwerts der Batterierestlaufzeit aus den Informationen, dem geplanten zeitlichen Abstand zukünftiger Messungen und dem geplanten zeitlichen Abstand von Funkübertragungen;
wobei der externe Server oder die Cloud (110) eingerichtet ist, die Parametrierung des Messgeräts zu ändern, wenn der berechnete Mindestwert der Batterierestlaufzeit unter einen bestimmten Schwellwert fällt.

2. Batteriebetriebenes Füllstandmessgerät (100) nach Anspruch 1,
wobei die Restlebensdauerbestimmungseinrichtung (109, 109a) eine Zähleinrichtung (121) aufweist, welche eingerichtet ist, die vom Füllstandmessgerät durchgeführten Messungen zu zählen.

3. Batteriebetriebenes Füllstandmessgerät (100) nach Anspruch 1 oder 2,
wobei die Zähleinrichtung (121) eingerichtet ist, die Anzahl an Messwertanzeigeereignissen und/oder an Messwertübermittlungen an einen externen Empfänger zu zählen.

4. Batteriebetriebenes Füllstandmessgerät (100) nach einem der vorhergehenden Ansprüche,
wobei die Restlebensdauerbestimmungseinrichtung (109, 109a) ein Coulomb-Meter (120) aufweist, welches eingerichtet ist, die der Batterie entnommene Ladungsmenge zu messen.

5. Batteriebetriebenes Füllstandmessgerät (100) nach Anspruch 4,
wobei das Coulomb-Meter (120) in einer Batteriespannungsregeleinheit (107) des Füllstandmessgeräts (100) integriert ist.

6. Batteriebetriebenes Füllstandmessgerät (100) nach einem der vorhergehenden Ansprüche,
wobei die Restlebensdauerbestimmungseinrichtung (109, 109a) eine Batteriespannungsregeleinheit (107) aufweist, welche eingerichtet ist, die Spannung der Batterie zu messen.

7. Batteriebetriebenes Füllstandmessgerät (100) nach einem der vorhergehenden Ansprüche,
wobei die Restlebensdauerbestimmungseinrichtung (109, 109a) einen Temperatursensor (122) aufweist, welcher eingerichtet ist, die Temperatur der Batterie zu messen.

8. Batteriebetriebenes Füllstandmessgerät (100) nach einem der vorhergehenden Ansprüche,
wobei die Restlebensdauerbestimmungseinrichtung (109, 109a) eine Echtzeituhr (123) aufweist, welche eingerichtet ist, das aktuelle Datum und/oder die aktuelle Zeit zu bestimmen und mit einem Zeitstempel der Batterie zu vergleichen.

9. Batteriebetriebenes Füllstandmessgerät (100) nach einem der vorhergehenden Ansprüche, weiter aufweisend:
einen Datenspeicher (124), in welchem Informationen über die Art und die Kapazität der Batterie gespeichert sind.

10. Batteriebetriebenes Füllstandmessgerät (100) nach einem der vorhergehenden Ansprüche,
wobei die Restlebensdauerbestimmungseinrichtung (109, 109a) eingerichtet ist, die Anzahl der vom Füllstandmessgerät durchgeführten Messungen, die Anzahl an Messwertanzeigeereignissen und/oder an Messwertübermittlungen an den externen Empfänger, die der Batterie entnommene Ladungsmenge, die Spannung der Batterie und/oder das aktuelle Datum, die aktuelle Zeit und/oder die Informationen über die Art und die Kapazität der Batterie in die bereitgestellten Informationen aufzunehmen oder bei der Berechnung des Mindestwerts der Batterierestlaufzeit zu berücksichtigen.

11. Batteriebetriebenes Füllstandmessgerät (100) nach einem der vorhergehenden Ansprüche,
wobei die Batterie (102) im Füllstandmessgerät (100) fest verbaut ist, so dass sie nicht ausgewechselt werden kann.

12. Batteriebetriebenes Füllstandmessgerät (100) nach einem der vorhergehenden Ansprüche,
wobei das Füllstandmessgerät (100) ausschließlich batteriebetrieben ist.

13. Batteriebetriebenes Füllstandmessgerät (100) nach einem der vorhergehenden Ansprüche, wobei die Restlebensdauerbestimmungseinrichtung (109, 109a) eingerichtet ist, eine geringe Restlebensdauer dem Nutzer des Sensors zu signalisieren.

14. Verfahren zum Bestimmen einer Restlebensdauer einer Batterie (102) eines Messgeräts (100), das Verfahren aufweisend die Schritte:
Bereitstellen von Informationen, aus denen sich ein Mindestwert der Batterierestlaufzeit berechnen lässt, durch eine Restlebensdauerbestimmungseinrichtung (109, 109a) des Messgeräts (100);
Berechnen des Mindestwerts der Batterierestlaufzeit aus diesen Informationen, dem geplanten zeitlichen Abstand zukünftiger Messungen und dem geplanten zeitlichen Abstand von Funkübertragungen durch die Restlebensdauerbestimmungseinrichtung (109, 109a) oder einen externen Server oder eine Cloud (110);
Ändern einer Parametrierung des Messgeräts durch den externen Server oder die Cloud (110), wenn der berechnete Mindestwert der Batterierestlaufzeit unter einen bestimmten Schwellwert fällt.

15. Programmelement, das, wenn es auf einem Prozessor (108) eines Messgeräts (100) ausgeführt wird, das Messgerät anleitet, die Schritte nach Anspruch 14 durchzuführen.

16. Computerlesbares Medium, auf dem ein Programmelement nach Anspruch 15 gespeichert ist.

## Claims

1. Battery-operated fill level measuring device (100) and external server or cloud (110), the battery-operated fill level measuring device comprising:
a battery (102);
a remaining service life determining device (109, 109a) configured to provide information, and to calculate a minimum value of the remaining battery service life from the information, the planned time interval of future measurements and the planned time interval of radio transmissions;
wherein the external server or the cloud (110) is configured to change the parameterization of the fill level measuring device if the calculated minimum value of the remaining battery service life falls below a certain threshold value.

2. Battery-operated fill level measuring device (100) according to claim 1,
wherein the remaining service life determination device (109, 109a) comprises a counting device (121) which is arranged to count the measurements made by the fill level measuring device.

3. Battery-operated fill level measuring device (100) according to claim 1 or 2,
wherein the counting device (121) is configured to count the number of measured value display events and/or measured value transmissions to an external receiver.

4. Battery-operated fill level measuring device (100) according to one of the preceding claims,
wherein the remaining service life determination device (109, 109a) comprises a coulomb meter (120) which is configured to measure the amount of charge removed from the battery.

5. Battery-operated fill level measuring device (100) according to claim 4,
wherein the Coulomb meter (120) is integrated in a battery voltage regulating unit (107) of the fill level measuring device (100).

6. Battery-operated fill level measuring device (100) according to one of the preceding claims,
wherein the remaining service life determining device (109, 109a) comprises a battery voltage regulating unit (107) which is configured to measure the voltage of the battery.

7. Battery-operated fill level measuring device (100) according to one of the preceding claims,
wherein the remaining service life determination device (109, 109a) comprises a temperature sensor (122) which is configured to measure the temperature of the battery.

8. Battery-operated fill level measuring device (100) according to one of the preceding claims,
wherein the remaining service life determination device (109, 109a) has a realtime clock (123) which is configured to determine the current date and/or the current time and to compare it with a time stamp of the battery.

9. Battery-operated fill level measuring device (100) according to any one of the preceding claims, further comprising:
a data memory (124) in which information about the type and capacity of the battery is stored.

10. Battery-operated fill level measuring device (100) according to one of the preceding claims,
wherein the remaining service life determining device (109, 109a) is configured to include the number of measurements performed by the fill level measuring device, the number of measured value display events and/or measured value transmissions to the external receiver, the amount of charge taken from the battery, the voltage of the battery and/or the current date, the current time and/or the information on the type and capacity of the battery in the information provided or taken into account in the calculation of the minimum value of the battery remaining life.

11. Battery-operated fill level measuring device (100) according to one of the preceding claims,
wherein the battery (102) is permanently installed in the fill level measuring device (100) so that it cannot be replaced.

12. Battery-operated fill level measuring device (100) according to one of the preceding claims,
whereby the fill level measuring device (100) is exclusively battery-operated.

13. Battery-operated fill level measuring device (100) according to one of the preceding claims, wherein the remaining service life determining device (109, 109a) is set up to signal a low remaining service life to the user of the sensor.

14. Method of determining a remaining service life of a battery (102) of a measuring device (100), the method comprising the steps of:
Providing information from which a minimum value of the remaining battery service life can be calculated by a remaining service life determining device (109, 109a) of the measuring device (100);
Calculating the minimum value of the remaining battery service life from this information, the planned time interval of future measurements and the planned time interval of radio transmissions by the remaining battery service life determination device (109, 109a) or an external server or cloud (110);
Changing a parameterization of the measuring device by the external server or the cloud (110) if the calculated minimum value of the battery test runtime falls below a certain threshold value.

15. Program element which, when executed on a processor (108) of a measuring device (100), instructs the measuring device to perform the steps according to claim 14.

16. Computer-readable medium on which a program element according to claim 15 is stored.

## Revendications

1. Appareil de mesure de niveau de remplissage alimenté par batterie (100) et serveur externe ou nuage (110), l'appareil de mesure de niveau de remplissage alimenté par batterie comportant :
une batterie (102) ;
un dispositif de détermination de durée de vie restante (109, 109a), configuré pour fournir des informations et pour calculer une valeur minimale de la durée de vie restante de la batterie à partir des informations, de l'intervalle de temps prévu pour de futures mesures et de l'intervalle de temps prévu pour des transmissions radio ;
dans lequel le serveur externe ou le nuage (110) est configuré pour changer le paramétrage de l'appareil de mesure lorsque la valeur minimale calculée de la durée de vie restante de la batterie chute en dessous d'une valeur de seuil prédéterminée.

2. Appareil de mesure de niveau de remplissage alimenté par batterie (100) selon la revendication 1,
dans lequel le dispositif de détermination de durée de vie restante (109, 109a) comporte un dispositif de comptage (121) qui est configuré pour compter des mesures effectuées par l'appareil de mesure de niveau de remplissage.

3. Appareil de mesure de niveau de remplissage alimenté par batterie (100) selon la revendication 1 ou 2,
dans lequel le dispositif de comptage (121) est configuré pour compter le nombre d'événements d'affichage de valeurs mesurées et/ou de transmissions de valeurs mesurées à un récepteur externe.

4. Appareil de mesure de niveau de remplissage alimenté par batterie (100) selon l'une des revendications précédentes, dans lequel le dispositif de détermination de durée de vie restante (109, 109a) comporte un coulomètre (120) qui est configuré pour mesurer la quantité de charge prélevée sur la batterie.

5. Appareil de mesure de niveau de remplissage alimenté par batterie (100) selon la revendication 4,
dans lequel le coulomètre (120) est intégré dans une unité de régulation de tension de batterie (107) de l'appareil de mesure de niveau de remplissage (100).

6. Appareil de mesure de niveau de remplissage alimenté par batterie (100) selon l'une des revendications précédentes, dans lequel le dispositif de détermination de durée de vie restante (109, 109a) comporte une unité de régulation de tension de batterie (107) qui est configurée pour mesurer la tension de la batterie.

7. Appareil de mesure de niveau de remplissage alimenté par batterie (100) selon l'une des revendications précédentes, dans lequel le dispositif de détermination de durée de vie restante (109, 109a) comporte un capteur de température (122) qui est configuré pour mesurer la température de la batterie.

8. Appareil de mesure de niveau de remplissage alimenté par batterie (100) selon l'une des revendications précédentes, dans lequel le dispositif de détermination de durée de vie restante (109, 109a) comporte une horloge en temps réel (123) qui est configurée pour déterminer la date actuelle et/ou l'heure actuelle et pour les comparer avec un horodatage de la batterie.

9. Appareil de mesure de niveau de remplissage alimenté par batterie (100) selon l'une des revendications précédentes, comportant en outre :
une mémoire de données (124) dans laquelle sont stockées des informations sur le type et la capacité de la batterie.

10. Appareil de mesure de niveau de remplissage alimenté par batterie (100) selon l'une des revendications précédentes, dans lequel le dispositif de détermination de durée de vie restante (109, 109a) est configuré pour enregistrer dans les informations fournies le nombre de mesures réalisées par l'appareil de mesure de niveau de remplissage, le nombre d'événements d'affichage de valeurs mesurées et/ou de transmissions de valeurs mesurées au récepteur externe, la quantité de charge prélevée sur la batterie, la tension de la batterie et/ou la date actuelle, l'heure actuelle et/ou les informations sur le type et la capacité de la batterie ou d'en tenir compte lors du calcul de la valeur minimale de la durée de vie restante de la batterie.

11. Appareil de mesure de niveau de remplissage alimenté par batterie (100) selon l'une des revendications précédentes, dans lequel la batterie (102) est montée de manière fixe dans l'appareil de mesure de niveau de remplissage (100) de sorte qu'elle ne peut pas être remplacée.

12. Appareil de mesure de niveau de remplissage alimenté par batterie (100) selon l'une des revendications précédentes, dans lequel l'appareil de mesure de niveau de remplissage (100) est exclusivement alimenté par batterie.

13. Appareil de mesure de niveau de remplissage alimenté par batterie (100) selon l'une des revendications précédentes, dans lequel le dispositif de détermination de durée de vie restante (109, 109a) est configuré pour signaler une faible durée de vie restante à l'utilisateur du capteur.

14. Procédé pour déterminer une durée de vie restante d'une batterie (102) d'un appareil de mesure (100), le procédé comportant les étapes consistant à :
fournir des informations qui permettent de calculer une valeur minimale de la durée de vie restante de la batterie par un dispositif de détermination de durée de vie restante (109, 109a) de l'appareil de mesure (100) ;
calculer la valeur minimale de la durée de vie restante de la batterie à partir de ces informations, l'intervalle de temps prévu pour de futures mesures et l'intervalle de temps prévu pour des transmissions radio par l'intermédiaire du dispositif de détermination de durée de vie restante (109, 109a) ou d'un serveur externe ou d'un nuage (110) ;
changer un paramétrage de l'appareil de mesure par le serveur externe ou le nuage (110) lorsque la valeur minimale calculée de la durée de vie restante de la batterie chute en dessous d'une valeur de seuil prédéterminée.

15. Élément de programme qui, lorsqu'il est exécuté sur un processeur (108) d'un appareil de mesure (100), guide l'appareil de mesure à mettre en œuvre les étapes selon la revendication 14.

16. Support lisible par ordinateur sur lequel est stocké un élément de programme selon la revendication 15.
